# FASCICULE DE BREVET EUROPEEN

(11) **EP 0 509 073 B1**
(45) Date de publication et mention de la délivrance du brevet: **01.04.1998**
(21) Numéro de dépôt: 91918515.7
(22) Date de dépôt: 17.10.1991
(51) Int. Cl.: H03K 17/95, G01D 21/00

(54) **DETECTEUR DU TYPE DEUX FILS A TENSION REGULEE**
ZWEIDRAHTSENSOR MIT GEREGELTER SPANNUNG
REGULATED VOLTAGE DUAL-WIRE-TYPE DETECTOR

(30) Priorité: 18.10.1990 FR 9012883
(43) Date de publication de la demande: 21.10.1992
(73) Titulaire: SCHNEIDER ELECTRIC SA, 92100 Boulogne Billancourt (FR)
(72) Inventeur: CHARRIER, Pierre, F-86440 Migne-Auxances (FR); LEONARD, Didier, F-16290 Hiersac (FR)
(74) Mandataire: Carias, Alain
(86) Numéro de dépôt international: FR9100814
(87) Numéro de publication internationale: WO9207426

(56) Documents cités:
- DE-A- 3 321 838
- DE-A- 3 828 428
- FR-A- 2 656 705
- GB-A- 2 219 862
- US-A- 4 672 230

## Description

La présente invention concerne un détecteur comprenant un capteur associé à un circuit électronique de traitement, ainsi qu'un dispositif de commutation et de régulation de tension agencé pour commuter une charge en fonction de la sortie du circuit de traitement, une source de tension étant placée en série avec la charge pour alimenter celle-ci ainsi que le détecteur.

Les détecteurs ainsi agencés sont qualifiés de détecteurs "deux fils" car ils sont reliés à la charge et à la source par deux conducteurs seulement, en s'alimentant ainsi en série avec la charge. Il s'agit, par exemple, de détecteurs de proximité ou analogues générant une oscillation dont la grandeur à détecter modifie les caractéristiques.

Pour améliorer les performances d'un tel détecteur, on cherche notamment à minimiser, d'une part, le courant résiduel qu'il consomme lorsqu'il n'est pas traversé par le courant de fonctionnement de la charge (état arrêt ou "off"). d'autre part, la tension de déchet qu'il génère lorsqu'il est traversé par ce courant de fonctionnement (état marche ou "on"). Il est, de plus, souhaitable de réguler la tension fournie au capteur à partir de la source, dans les états marche et arrêt et, particulièrement, dans les phases transitoires au cours desquelles le détecteur passe de l'état marche à l'état arrêt, et vice-versa.

Le brevet DE 38 28 428 propose à cet effet une solution dans laquelle la régulation parallèle est réalisée grâce à une diode Zener en série avec un interrupteur commandable constitué par un transistor à effet de champ.

L'invention a en particulier pour but d'assurer dans un détecteur de ce type, une régulation satisfaisante de la tension fournie au circuit de traitement dans les différents états de fonctionnement et, cela, en recourant à des moyens électroniques simples.

Elle a pour autre but de réduire la dissipation d'énergie dans ces moyens électroniques et, dans certains cas, de les rendre propres à protéger le détecteur contre les surintensités.

Pour parvenir à ces résultats, l'invention propose un détecteur comprenant un capteur associé à un circuit électronique de traitement et un dispositif de commutation et de régulation de tension susceptible d'être relié, via deux bornes du détecteur, à un circuit d'utilisation comprenant une charge en série avec une source de tension, le dispositif étant, d'une part, commandé par le circuit de traitement pour ouvrir et, respectivement, fermer le circuit d'utilisation selon l'état du capteur et agissant, d'autre part, pour réguler la tension d'alimentation du circuit de traitement, le dispositif de commutation et de régulation comprenant deux dispositifs de commutation associés à deux moyens de régulation respectivement de type série et de type parallèle, les deux moyens de commutation :
- étant disposés dans une branche de commutation dont les extrémités sont connectées aux bornes du détecteur et dont une extrémité et un point intermédiaire sont reliés à des bornes du circuit de traitement, et
- étant tels que, dans un premier état du capteur, le dispositif de commutation met en oeuvre les moyens de régulation de type parallèle de la tension aux bornes du circuit de traitement et, dans un deuxième état du capteur, le dispositif de commutation met en oeuvre les moyens de régulation de type série de la tension aux bornes du circuit de traitement, tandis qu'il inhibe les moyens de régulation de type parallèle,

ledit dispositif de commutation étant constitué de deux interrupteurs-amplificateurs disposés en série, le premier de ces interrupteurs-amplificateurs étant à gain variable et assurant en outre la fonction de régulation série.

Selon l'invention, ce dispositif est caractérisé en ce que ou bien le premier interrupteur-amplificateur est un transistor à grille isolée reliée à un circuit élévateur de tension qui maintient le transistor saturé dans le premier état du capteur, et à un réseau à seuil de tension qui régule la tension de grille dans un second état du capteur, ou bien le premier interrupteur-amplificateur comprend d'une part un thyristor placé dans la branche de commutation et dont la gâchette forme le point intermédiaire de la branche et, d'autre part, un transistor à grille isolée monté entre l'anode et la gâchette du thyristor, la grille du transistor étant reliée à un réseau à seuil de tension, de sorte que dans le premier état du capteur, le transistor est bloqué et le thyristor passant, tandis que dans le deuxième état du capteur, le thyristor est bloqué et le transistor passant, et en ce que le deuxième interrupteur-amplificateur qui est à gain variable et qui assure la régulation de type parallèle, présente une électrode de commande pilotée par la sortie d'un amplificateur différentiel qui compare une tension représentative de la tension aux bornes du circuit de traitement à une tension de référence.

A l'état marche, qui correspond au premier état du capteur, l'interrupteur-amplificateur qui fonctionne en tant que régulateur parallèle est parcouru par le même courant que celui qui circule dans l'interrupteur-amplificateur qui assure la régulation de type série. Ce dernier est notamment choisi et agencé pour que sa chute de tension soit aussi réduite que possible.

Le transistor à grille isolée réalise dans le deuxième état du capteur une régulation série, par la connexion de sa grille à un élément de seuil tel qu'une diode Zener polarisée à partir de la tension d'alimentation au moyen d'une résistance. Dans le premier état du capteur, la conduction de ce transistor est assurée, soit par saturation du transistor à grille isolée à l'aide de moyens adéquants, soit par mise en conduction d'un thyristor shuntant ledit transistor.

La description va a présent être faite d'un exemple de réalisation non limitatif de l'invention pour expliciter celle-ci en regard des dessins annexés.
La figure 1 représente schématiquement un détecteur de proximité conforme à l'invention;
La figure 2 montre plus en détail le schéma d'un premier mode de réalisation du détecteur de proximité selon l'invention ;
La figure 3 montre le schéma d'un second mode de réalisation du détecteur selon l'invention.

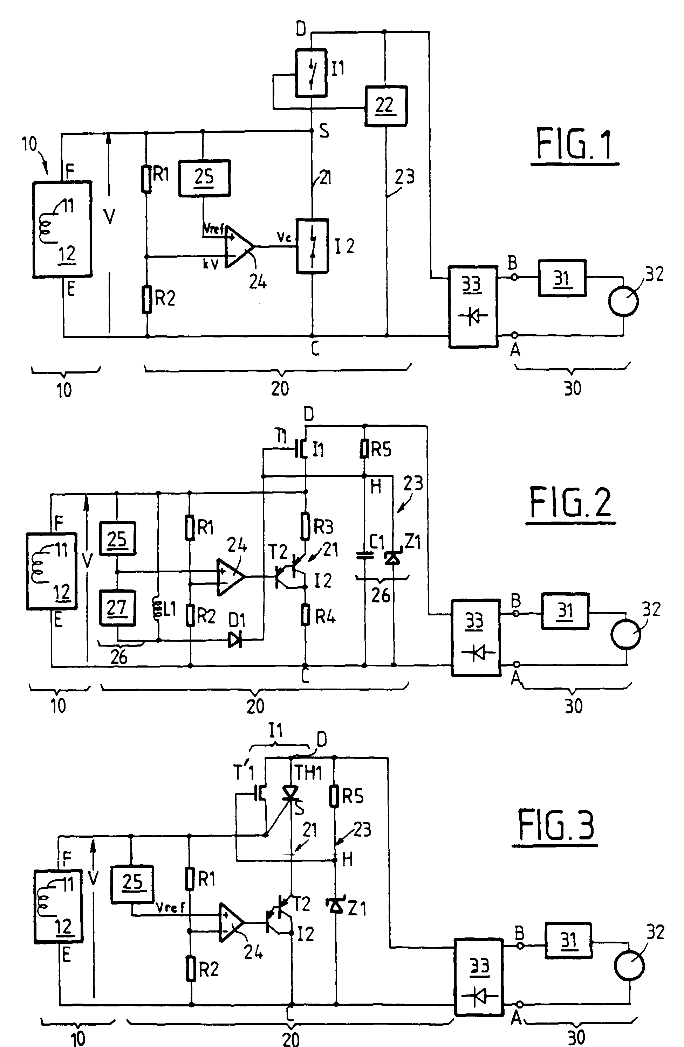

Le détecteur de proximité illustré sur la figure 1 comprend un ensemble capteur 10 comprenant un élément capteur 11 proprement dit associé à un circuit électronique de traitement 12. L'élément capteur 11 est destiné à détecter la variation d'une présence ou d'une grandeur. En fonction de cette variation, le circuit 12 prend deux états traduits par le niveau haut ou bas d'une tension V. Le détecteur comprend, de plus, un dispositif de commutation et de régulation de tension 20 qui établit et, respectivement, arrête le fonctionnement d'une charge en fonction de la tension V aux bornes du circuit 12.

Le dispositif de commutation 20 est susceptible d'être relié, via deux bornes A et B du détecteur, à un circuit d'utilisation 30 comprenant une charge 31 en série avec une source de tension 32. La liaison du dispositif 20 avec la charge et la source s'effectue au moyen de deux conducteurs, la source alimentant la charge et le détecteur. La source de tension est une source de tension continue ou une source de tension alternative, un redresseur 33 étant, dans ce dernier cas, prévu à l'entrée du détecteur ; le dispositif de commutation 20 a un rôle de commutation de la charge 31 et un rôle d'interface entre l'ensemble capteur 10 et le circuit d'utilisation 30, régulant la tension fournie par la source de tension et délivrant à des bornes E, F du circuit 12, une tension régulée quel que soit l'état de celui-ci.

Lorsque le détecteur ouvre le circuit d'utilisation 30, le courant résiduel consommé par ses circuits électroniques doit être le plus faible possible ; de même, lorsque le détecteur ferme le circuit d'utilisation, la tension de déchet qu'il génère et qui alimente ses circuits électroniques doit être la plus faible possible.

La tension d'alimentation fournie aux bornes E, F du circuit 12 est régulée, d'une part, par un premier interrupteur I1 lorsque le détecteur est au repos et la charge hors fonctionnement, d'autre part, par un deuxième interrupteur I2 véhiculant le courant de charge lorsque le détecteur est actif et la charge en fonctionnement. Les interrupteurs I1, I2 sont disposés en série dans une branche de commutation 21 du dispositif 20. Les deux extrémités C, D de la branche 21 sont connectées aux bornes A, B du détecteur. L'extrémité C et un point intermédiaire S de la branche sont reliés aux bornes E, F du circuit de traitement 12.

La figure 2 montre plus en détail la circuiterie d'un premier mode de réalisation du détecteur de proximité conforme à l'invention. Le capteur 11 de ce détecteur génère une oscillation qui est plus ou moins amortie selon la distance d'un objet à détecter, cet amortissement étant convenablement traduit en signal de tension V par le circuit de traitement.

Une électrode de commande du premier interrupteur Il est reliée à un élément de seuil 22, par exemple constitué par une diode Zener ou d'autres composants analogues, placé dans une branche 23 parallèle à la branche 21.

Le deuxième interrupteur I2 est commandé par une boucle de réaction comprenant un amplificateur différentiel 24. A l'entrée non inverseuse de l'amplificateur 24 est appliquée une tension précise et stable Vref élaborée par un générateur 25 par exemple du type band-gap ; à l'entrée inverseuse de l'amplificateur 24 est appliquée, au moyen d'un pont diviseur R1, R2, une fraction de la tension V, de façon à piloter l'interrupteur I2 par le signal d'erreur Vc. L'interrupteur I2 régule ainsi la tension au point S de la branche 21 intermédiaire entre I1 et I2.

Dans la forme d'exécution illustrée figure 2, l'interrupteur I1 comprend un transistor à grille isolée T1. Dans cet exemple, il s'agit d'un transistor MOS dont le drain est relié à l'extrémité D de la branche 21 et la source au point S. La grille de T1 est reliée, d'une part, à un point milieu H de la branche 23, entre une résistance R5 et une diode Zener Z1 mise en parallèle avec un condensateur C1, d'autre part, via une diode D1 à un circuit élévateur de tension 26. Le circuit élévateur de tension 26 comporte un générateur d'impulsions ou horloge 27 connecté au générateur 25 de tension de référence et une inductance L1 connectée entre le point S et l'anode de D1.

L'interrupteur I2 est constitué par un montage bipolaire Darlington T2 dont l'émetteur principal est relié au point S via une résistance R3 et le collecteur au point C via une résistance R4. La base de commande de T2 est reliée à la sortie de l'amplificateur 24. A la place d'un Darlington, on peut choisir pour I2 un simple transistor bipolaire ou un transistor à grille isolée.

Le détecteur de la figure 2 fonctionne de la manière suivante. Lorsque le capteur détermine le fonctionnement de la charge 31, l'horloge 27 associée à la self L1 applique à la grille du transistor T1 une tension élevée, par exemple de l'ordre de 12 volts, qui en entraîne la saturation. L'inductance L1 sert aussi à provoquer une surtension à l'ouverture et à injecter un courant dans C1, Z1. Le circuit d'utilisation 30 se ferme par la branche de commutation 21 qui est passante. Le transistor Darlington T2 maintient un potentiel constant sur la source du transistor T1 grâce à la boucle de régulation à amplificateur 24.

Lorsqu'il se produit une surintensité, soit à cause d'une charge 31 de faible valeur, soit à cause d'un court-circuit, le courant élevé qui traverse la branche de commutation 21 entraîne une augmentation de la chute de tension aux bornes de R3, R4 qui, s'ajoutant à la tension collecteur-émetteur de T2, joue un rôle limiteur. La chute de tension dans R3 est détectée par la boucle de réaction qui, au bout d'une durée par exemple égale à 100 µs pour un court-circuit et à 20 ms pour une surcharge, bloque l'interrupteur T2.

Lorsque le capteur détermine l'arrêt du fonctionnement de la charge 31, l'amplificateur 24 n'est pas polarisé et provoque le blocage du montage Darlington T2. L'élévateur de tension 27 n'est pas activé et le transistor T1 est passant avec une tension de grille régulée par le réseau R5, Z1, par exemple à 12 volts à partir du potentiel au point D, pour produire une tension V régulée de 8 volts par exemple.

Dans la forme d'exécution non protégée illustrée figure 3, l'interrupteur I1 comprend, d'une part, un thyristor TH1 placé dans la branche 21, passant à l'état marche et bloqué à l'état arrêt et, d'autre part, un transistor MOS T'1 shuntant le thyristor à l'état arrêt et bloqué à l'état marche.

L'interrupteur I2 est, comme précédemment, constitué par un montage bipolaire Darlington T2. Le transistor T'1 est en parallèle au trajet anode-gâchette du thyristor TH1, dont l'anode est reliée au point D et la cathode à l'émetteur de T2. La gâchette du thyristor, formant le point S mentionné plus haut, est reliée à la borne F du circuit de traitement 12. La grille du transistor T'1 est simplement reliée au point H de la branche 23.

Le détecteur de la figure 3 fonctionne comme suit. Lorsque le capteur fait fonctionner la charge 31, le thyristor TH1 est passant et le transistor T'1 bloqué. Le circuit de traitement 12 est alimenté via le chemin anode-gâchette du thyristor. La régulation de la tension V aux bornes du circuit 12 est assurée par le montage Darlington T2 en fonction de la comparaison effectuée par l'amplificateur 24 entre la tension de référence Vref et la fraction de la tension V que détermine le pont diviseur R1, R2. Le Darlington T2 régule la tension de cathode de TH1. La tension de déchet de la branche 21 reste faible.

Lorsque le capteur arrête l'alimentation de la charge 31, le transistor T2 est bloqué, ce qui entraîne le blocage du thyristor TH1 et la mise en conduction du transistor T'1. La régulation série souhaitée est alors assurée par la polarisation de grille de T'1 au moyen de R5, Z1.

L'invention est applicable à des détecteurs de tous types.

## Revendications

1. Détecteur comprenant un capteur (11) associé à un circuit électronique de traitement (12) et un dispositif de commutation et de régulation de tension (20) susceptible d'être relié, via deux bornes (A, B) du détecteur, à un circuit d'utilisation (30) comprenant une charge en série avec une source de tension, le dispositif étant, d'une part,commandé par le circuit de traitement pour ouvrir et, respectivement, fermer le circuit d'utilisation selon l'état du capteur et agissant, d'autre part, pour réguler la tension d'alimentation du circuit de traitement, le dispositif de commutation et de régulation comprenant deux dispositifs de commutation associés à deux moyens de régulation respectivement de type série et de type parallèle, les deux moyens de comutation :
- étant disposés dans une branche de commutation (21) dont les extrémités (C, D) sont connectées aux bornes (A, B) du détecteur et dont une extrémité (C) et un point intermédiaire (S) sont reliés à des bornes (E, F) du circuit de traitement, et
- étant tels que, dans un premier état du capteur, le dispositif de commutation met en oeuvre les moyens de régulation de type parallèle de la tension (V) aux bornes du circuit de traitement et, dans un deuxième état du capteur, le dispositif de commutation met en oeuvre les moyens de régulation de type série de la tension (V) aux bornes du circuit de traitement, tandis qu'il inhibe les moyens de régulation de type parallèle,
ledit dispositif de commutation étant constitué de deux interrupteurs-amplificateurs (I1, I2) disposés en série, le premier de ces interrupteurs-amplificateurs (I1) étant à gain variable et assurant en outre la fonction de régulation série,
caractérisé en ce que le premier interrupteur-amplificateur (I1) est un transistor (T1) à grille isolée reliée à un circuit élévateur de tension (26) qui maintient le transistor saturé dans le premier état du capteur, et à un réseau à seuil de tension (R5, Z1) qui régule la tension de grille dans le second état du capteur, et en ce que le deuxième interrupteur-amplificateur (I2) qui est à gain variable et qui assure la régulation de type parallèle, présente une électrode de commande pilotée par la sortie Vc d'un amplificateur différentiel qui compare une tension représentative de la tension (V) aux bornes du circuit de traitement (12) à une tension de référence (Vref).

2. Détecteur selon la revendication 1, caractérisé par le fait qu'au moins une résistance (R3, R4) est placée dans la branche de commutation (21) pour contribuer avec les interrupteurs-amplificateurs (I1, I2) et leurs moyens de commande à limiter les surintensités dans la branche de commutation (21).

3. Détecteur comprenant un capteur (11) associé à un circuit électronique de traitement (12) et un dispositif de commutation et de régulation de tension (20) susceptible d'être relié, via deux bornes (A, B) du détecteur, à un circuit d'utilisation (30) comprenant une charge en série avec une source de tension, le dispositif étant, d'une part,commandé par le circuit de traitement pour ouvrir et, respectivement, fermer le circuit d'utilisation selon l'état du capteur et agissant, d'autre part, pour réguler la tension d'alimentation du circuit de traitement, le dispositif de commutation et de régulation comprenant deux dispositifs de commutation associés à deux moyens de régulation respectivement de type série et de type parallèle, les deux moyens de commutation :
- étant disposés dans une branche de commutation (21) dont les extrémités (C, D) sont connectées aux bornes (A, B) du détecteur et dont une extrémité (C) et un point intermédiaire (S) sont reliés à des bornes (E, F) du circuit de traitement, et
- étant tels que, dans un premier état du capteur, le dispositif de commutation met en oeuvre les moyens de régulation de type parallèle de la tension (V) aux bornes du circuit de traitement et, dans un deuxième état du capteur, le dispositif de commutation met en oeuvre les moyens de régulation de type série de la tension (V) aux bornes du circuit de traitement, tandis qu'il inhibe les moyens de régulation de type parallèle,
ledit dispositif de commutation étant constitué de deux interrupteurs-amplificateurs (I1, I2) disposés en série, le premier de ces interrupteurs-amplificateurs (I1) étant à gain variable et assurant en outre la fonction de régulation série,
caractérisé en ce que le premier interrupteur-amplificateur I1 comprend d'une part un thyristor (TH1) placé dans la branche de commutation (21) et dont la gâchette forme le point intermédiaire (S) de la branche, d'autre part, un transistor (T'1) à grille isolée monté entre l'anode et la gâchette du thyristor, la grille du transistor (T'1) étant reliée à un réseau à seuil de tension (R5, Z1), de sorte que dans le premier état du capteur, le transistor est bloqué et le thyristor passant, tandis que dans le deuxième état du capteur, le thyristor est bloqué et le transistor passant, et en ce que le deuxième interrupteur-amplificateur I2 qui est à gain variable et qui assure la régulation de type parallèle, présente une électrode de commande pilotée par la sortie Vc d'un amplificateur différentiel qui compare une tension représentative de la tension (V) aux bornes du circuit de traitement (12) à une tension de référence (Vref).

## Patentansprüche

1. Sensor, der einen Geber (11) umfaßt, der einem elektronischen Verarbeitungskreis (12) und einer Umschalt- und Spannungsregelvorrichtung (20) zugeordnet ist, die über zwei Klemmen (A, B) des Sensors an einen Verwendungskreis (30) mit einer mit einer Spannungsquelle in Serie geschalteten Last angeschlossen werden kann, wobei die Vorrichtung einerseits vom Verarbeitungskreis zum Öffnen bzw. Schließen des Verwendungskreises je nach Geberzustand gesteuert wird, und andererseits wirkt, um die Versorgungsspannung des Verarbeitungskreises zu regeln, wobei die Umschalt- und Regelvorrichtung zwei Umschaltvorrichtungen umfaßt, die zwei Regelmitteln jeweils des Typs Serie und des Typs parallel zugeordnet sind, wobei die beiden Umschaltmittel:
- in einem Umschaltzweig (21) angeordnet sind, dessen Enden (C, D) an den Klemmen (A, B) des Sensors angeschlossen sind und dessen eines Ende (C) und ein Zwischenpunkt (S) mit Klemmen (E, F) des Verarbeitungskreises verbunden sind, und
- so beschaffen sind, daß die Umschaltvorrichtung in einem ersten Zustand des Gebers die Regelmittel des parallelen Typs der Spannung (V) an den Klemmen des Verarbeitungskreises einsetzt, und in einem zweiten Zustand des Gebers, die Umschaltvorrichtung die Regelmittel des Serientyps der Spannung (V) an den Klemmen des Verarbeitungskreises einsetzt, während sie die Regelmittel des parallelen Typs inhibiert,
wobei die besagte Umschaltvorrichtung aus zwei in Serie geschalteten Verstärker-Schaltern (I1, I2) besteht, wobei der erste dieser Verstärker-Schalter (I1) eine variable Verstärkung aufweist und weiters die Serienregelfunktion gewährleistet,
dadurch gekennzeichnet, daß der erste Verstärker-Schalter (I1) entweder ein Transistor (T1) mit isoliertem, an einem Spannungserhöhungskreis (26) angeschlossenem Gitter ist, das den Transistor im ersten Zustand des Gebers gesättigt hält, und das weiters an einem Netz mit Spannungsschwelle (R5, Z1) angeschlossen ist, das die Gitterspannung im zweiten Zustand des Gebers regelt, und daß der zweite Verstärker-Schalter (I2) mit variabler Verstärkung, der die Regelung des parallelen Typs gewährleistet, eine vom Ausgang Vc eines Differentialverstärkers angesteuerte Steuerelektrode aufweist, die eine für die an den Klemmen des Verarbeitungskreises (12) repräsentative Spannung (V) mit einer Referenzspannung (Vref) vergleicht.

2. Sensor nach Anspruch 1, dadurch gekennzeichnet, daß mindestens ein Widerstand (R3, R4) in einem Umschaltzweig (21) angeordnet ist, um gemeinsam mit den Verstärkern-Schaltern (I1, I2) und ihren Steuermitteln dazu beizutragen, die Überströme im Umschaltzweig (21) zu begrenzen.

3. Sensor, der einen Geber (11) umfaßt, der einem elektronischen Verarbeitungskreis (12) und einer Umschalt- und Spannungsregelvorrichtung (20) zugeordnet ist, die über zwei Klemmen (A, B) des Sensors an einen Verwendungskreis (30) mit einer mit einer Spannungsquelle in Serie geschalteten Last angeschlossen werden kann, wobei die Vorrichtung einerseits vom Verarbeitungskreis zum Öffnen bzw. Schließen des Verwendungskreises je nach Geberzustand gesteuert wird, und andererseits wirkt, um die Versorgungsspannung des Verarbeitungskreises zu regeln, wobei die Umschalt- und Regelvorrichtung zwei Umschaltvorrichtungen umfaßt, die zwei Regelmitteln jeweils des Typs Serie und des Typs parallel zugeordnet sind, wobei die beiden Umschaltmittel:
- in einem Umschaltzweig (21) angeordnet sind, dessen Enden (C, D) an den Klemmen (A, B) des Sensors angeschlossen sind und dessen eines Ende (C) und ein Zwischenpunkt (S) mit Klemmen (E, F) des Verarbeitungskreises verbunden sind, und
- so beschaffen sind, daß die Umschaltvorrichtung in einem ersten Zustand des Gebers die Regelmittel des parallelen Typs der Spannung (V) an den Klemmen des Verarbeitungskreises einsetzt, und in einem zweiten Zustand des Gebers, die Umschaltvorrichtung die Regelmittel des Serientyps der Spannung (V) an den Klemmen des Verarbeitungskreises einsetzt, während sie die Regelmittel des parallelen Typs inhibiert,
wobei die besagte Umschaltvorrichtung aus zwei in Serie geschalteten Verstärker-Schaltern (I1, I2) besteht, wobei der erste dieser Verstärker-Schalter (I1) eine variable Verstärkung aufweist und weiters die Serienregelfunktion gewährleistet,
dadurch gekennzeichnet, daß der erste Verstärker-Schalter I1 einerseits einen in einem Umschaltzweig (21) angeordneten Thyristor (TH1) umfaßt, dessen Gate den Zwischenpunkt (S) des Zweigs bildet, und andererseits einen Transistor (T'1) mit isoliertem Gitter, der zwischen der Anode und dem Gate des Thyristors angeordnet ist, wobei das Gitter des Transistors (T'1) an ein Netz mit Spannungsschwelle (R5, Z1) angeschlossen ist, so daß der Transistor im ersten Zustand des Gebers blockiert und der Thyristor durchlässig ist, während im zweiten Zustand des Gebers der Thyristor blockiert und der Transistor durchlässig ist, und daß der zweite Verstärker-Schalter I2 mit variabler Verstärkung, der die Regelung des parallelen Typs gewährleistet, eine vom Ausgang Vc eines Differentialverstärkers angesteuerte Steuerelektrode aufweist, die eine für die an den Klemmen des Verarbeitungskreises (12) repräsentative Spannung (V) mit einer Referenzspannung (Vref) vergleicht.

## Claims

1. Detector comprising a sensor (11) associated with an electronic processing circuit (12) and a switching and voltage regulation device (20) connectable through two terminals (A, B) on the detector, to a usage circuit (30) comprising a load in series with a voltage source, the device firstly being controlled by the processing circuit to open and close the usage circuit respectively depending on the state of the sensor, and secondly acting to regulate the processing circuit power supply voltage, the switching and regulation device comprising two switching devices associated with two regulation means, namely of the series type and of the parallel type, the two switching devices being:
- located in a switching branch (21) the ends (C, D) of which are connected to the detector terminals (A, B), and one end (C) and an intermediate point (S) of which are connected to terminals (E, F) of the processing circuit, and
- such that in a first state of the sensor, the switching device uses parallel type means for regulating the voltage (V) at the processing circuit terminals, and in a second state of the sensor the switching device uses series type means for regulating the voltage (V) at the terminals of the processing circuit, while it inhibits the parallel type regulation means,
said switching device being composed of two switches-amplifiers (I1, I2) placed in series, the first of these switches-amplifiers (I1) having variable gain and also performing the series regulation function, characterized by the fact that the first switch-amplifier (I1) is an isolated grid transistor (T1) connected to a voltage step-up circuit (26) which keeps the transistor saturated in the first state of the sensor, and to a voltage threshold network (R5, Z1) that regulates the grid voltage in the second state of the sensor, and by the fact that the second switch-amplifier (I2) which has variable gain and which provides parallel type regulation, includes a control electrode controlled by the output Vc from a differential amplifier that compares a voltage representative of the voltage (V) at the terminals of the processing circuit (12) with a reference voltage (Vref)

2. Detector according to claim 1,
characterized by the fact that at least one resistance (R3, R4) is placed in the switching branch (21) to work with switches-amplifiers (I1, I2) and their control means, to contribute to limiting overcurrents in the switching branch (21).

3. Detector comprising a sensor (11) associated with an electronic processing circuit (12) and a switching and voltage regulation device (20) connectable through two detector terminals (A, B) to a usage circuit (30) comprising a load in series with a voltage source, the device being firstly controlled by the processing circuit to open and close the usage circuit respectively depending on the state of the sensor, and also acting to regulate the processing circuit power supply voltage, the switching and regulation device comprising two switching devices associated with two regulation means, of the series type and of the parallel type, the two switching means being:
- placed in a switching branch (21), the ends (C, D) of which are connected to the detector terminals (A, B), and one end ( C ) and an intermediate point (S) of which are connected to the processing circuit terminals (E, F), and
- such that, in a first state of the sensor, the switching device uses parallel type means for regulating the voltage (V) at the processing circuit terminals, and in a second state of the sensor, the switching device uses series type means for regulating the voltage (V) at the processing circuit terminals, while it inhibits the parallel type regulation means,
said switching device being composed of two switches-amplifiers (I1, I2) placed in series, the first of these switches-amplifiers (I1) having variable gain and also performing the series regulation function, characterized by the fact that the first switch-amplifier I1 comprises firstly a thyristor (TH1) placed in the switching branch (21), and the gate of which forms the intermediate point (S) of the branch, and secondly an isolated grid transistor (T'1) mounted between the thyristor anode and the gate, the transistor grid (T'1) being connected to a voltage threshold network (R5, Z1) such that in the first state of the sensor, the transistor is blocked and the thyristor is conducting whereas in the second state of the sensor, the thyristor is blocked and the transistor is conducting, and by the fact that that the second switch-amplifier I2 which is of variable gain and which performs parallel type regulation, includes a control electrode controlled by the output Vc from a differential amplifier that compares a voltage representative of the voltage (V) at the processing circuit terminals (12) with a reference voltage (Vref).
